# NEW EUROPEAN PATENT SPECIFICATION

(11) **EP 0 284 062 B2**
(45) Date of publication and mention of the opposition decision: **10.10.2001**
(45) Mention of the grant of the patent: 10.06.1992
(21) Application number: 88104734.4
(22) Date of filing: 24.03.1988
(51) Int. Cl.: H01L 39/12, H01L 39/24

(54) **Ceramic oxide superconductive composite material**
Supraleitendes Materialgemisch aus Oxidkeramik
Matériau composé supraconducteur en oxyde de céramique

(30) Priority: 24.03.1987 JP 6936687; 27.03.1987 JP 7478287; 31.03.1987 JP 8040287
(43) Date of publication of application: 28.09.1988
(73) Proprietor: SUMITOMO ELECTRIC INDUSTRIES LIMITED, Osaka-shi, Osaka 541 (JP)
(72) Inventor: Nagata, Masayuki c/o Osaka Works of, Konohana-ku Osaka-shi Osaka-fu (JP); Yokota, Minoru c/o Osaka Works of, Konohana-ku Osaka-shi Osaka-fu (JP); Sato, Ken-ichi c/o Osaka Works of, Konohana-ku Osaka-shi Osaka-fu (JP)
(74) Representative: Hansen, Bernd, Dr. Dipl.-Chem.

(56) References cited:
- EP-A- 0 281 474
- EP-A- 0 282 286
- EP-A- 0 284 986
- EP-PS- 0 073 128
- EP-PS- 0 102 489
- WO-A-88/02355
- DE-A- 1 490 242
- DE-A- 1 640 198
- DE-A- 2 116 260
- JP-A- 56 852
- JP-A- 56 852
- JP-A- 56 856
- JP-A- 56 856
- JP-A- 56 856
- US-A- 3 817 746
- PHYSICAL REVIEW LETTERS, vol. 58, no. 4, 26th January 1987, pages 405-407, The American Physical Society; C.W. CHU et al.: "Evidence for superconductivity above 40 K in the La-Ba-Cu-O compound system"
- PHYSICAL REVIEW LETTERS, vol. 58, no. 9, 2nd March 1987, pages 908-910, The American Physical Society; M.K. WU et al.: "Superconductivity at 93 K in a new mixed-phase Y-Ba-Cu-O compound system at ambient pressure"
- ADVANCED MATERIALS & PROCESSES, vol. 132, no. 4, October 1987, pages 37-44, Metals Park, Ohio, US; L.E. MURR et al.: "Metal-matrix high-temperature superconductor"
- APPLIED PHYSICS LETTERS, vol. 52, no. 11, 14th March 1988, pages 927-929, American Institute of Physics; F.H. STREITZ et al.: "Superconducting Au-YBa2Cu3O7 composites"
- W. Buckel: "Supraleitung" 3.Auflage 1984, Physik Verlag Weinheim
- Proceedings of the Fifth International Cryogenic Engineering Conference (ICEC5), Kyoto 1974
- Phys. Rev, Letters, Vol.58, Nr.9, S.908-910

## Description

### BACKGROUND OF THE INVENTION

### Field of the Invention

The present invention relates to a ceramic oxide superconductive composite material which comprises a ceramic oxide superconductor and a non-superconductive material comprising at least one element which does not react with any of the elements of the ceramic oxide superconductor More particularly, it relates to a ceramic oxice superconductive composite material having a new construction whereby the ceramic oxide superconductor having a higher superconductive critical temperature can be effectively utilized.

### Description of Related Art

A superconductor exhibits complete diamagnetism under superconductive conditions and has no potential difference therein in spite of flow of stationary current in therein. By using this characteristic of the superconductor, many applications of superconductors as mediums for electric current have been proposed.

Application fields of superconductor include versatile technical fields such as an electric power field (e.g. MHD power generation, power transmission, energy storage, etc.), a motive power fieid (e.g. linear motor (magnetic levitation) trains, electromagnetic propulsion ships, etc.), and a measuring field in which the superconductor is used as a highly sensitive sensor for a magnetic field, a microwave, radiation and the like (e.g. NMR, therapy using π-meson, high energy physical experiment apparatus, etc.).

In addition, in the electronics including a Josephson element, the superconductor is expected to provide an element which can not only decrease power consumption but also work at a very high speed.

The superconductive phenomenon has been found in specific metals or organic compounds at extremely low temperatures. Namely, among classical superconductors, Nb₃Ge is said to have the highest critical temperature Tc for superconductivity of 23.2K and this temperature has been considered as the upper limit of Tc for a long time.

Hitherto, to realize the superconductive phenomenon, a superconductor should be cooled to a temperature lower than Tc with liquid helium which has a boiling point of 4.2.K. However, the use of liquid helium greatly increases technical burden and cost because of necessity of a cooling system including an apparatus for liquefying helium, which prevents practical application of the superconductor.

Recently it was reported that a sintered material comprising oxides of elements of IIa or IIIa group of the periodic table can act as a superconductor at a high critical temperature and is expected to accelerate practical application of superconductor technology. From already available reports, compound oxides having a crystal structure similar to the perovskite crystal structure such as (La.Ba)₂CuO₄ or (La Sr)₂CuO₄ are known as superconductors having high Tc. These compound oxides have Tc of 30 to 50 K, which is far higher than that of the classical superconductors (see for example Physical Review Letters. Vol. 58, No. 4, pp. 405 - 407. "Evidence for Superconductivity above 40 K in the La-Ea-Cu-O Compound System" by C. W. Chu et al.) In addition, a Ba-Y-Cu type superconductor is reported to have Tc higher than the liquid nitrogen temperature although its structure has not been identified.

EP-A-0 282 286, belonging to the prior art ander Art: 54 (3) and (4) EPC, discloses a superconducting composite comprising a ceramic oxide superconductor dispersed in an Ag matrix.

Since the ceramic oxide superconductor is prepared by sintering powdery metal compounds as raw material. It is inevitably porous. Due to porosity, the ceramic oxide superconductor has various drawbacks such that (a) an amount of electric current which can flow through the superconductor is small, namely a current density is small, (b) the superconductor has low mechanical strength and easily broken, and (c) if water is trapped in pores, hydroxide groups of water react with the material to deteriorate the superconductor.

It is known that the presence of oxygen in a sintering atmosphere greatly influences properties of superconductor in the preparation of ceramic oxide superconductor. For example, the raw materials are sintered in the air, a surface part of sintered material, for example, a surface layer of thickness of 0 5 mm from the surface which readily contacts the air has superior superconductive characteristics, namely higher critical temperature than inner parts of sintered material, although non-surface parts of sintered material may have superconductive characteristics.

In view of strength, the ceramic oxide superconductor which is prepared as a sintered material is usually brittle and requires great care to handle. That is, the ceramic oxide superconductor is easily broken or cracked by mechanical stress. Particularly, the ceramic oxide superconductor in the form of a wire is very easily broken. When the raw materials are formed in a porous state or a three-dimensional network to increase a surface area so as to make use of oxygen supply on the surface during sintering and to achieve desired superconductive characteristics, the sintered product becomes more fragile and its mechanical strength further decreases. Accordingly, it is practically difficult not only to plastically work the ceramic oxide superconductor but also to simply form. Therefore, its practical use has severe limitation.

Furthermore, it is very difficult to form a sintered superconductor from homogeneous polycrystal consisting of particles all having superconductive characteristics and, as a general property of the superconductor, the superconductive state may be locally broken by change of external magnetic field or cooling temperature. The ceramic oxide superconductor has smaller thermal conductivity and larger electrical resistance than the classical superconductors. Therefore, when the superconductive state is locally broken, such part of the superconductor is locally heated by electrical current which flows through the superconductor. If the cooling medium contacts the locally heated part of superconductor, it is explosively vaporized.

To prevent such explosive vaporization, the classical metal superconductor is processed in the form of a thin filament and a plural number of filaments are bundled by a good conductive material such as copper, which acts as a thermal conductor and a by-pass of electric current in case of breakage of superconductive state. However, it is difficult to process the ceramic oxide superconductor having higher Tc in the form of filament.

### SUMMARY OF THE INVENTION

One object of the present invention is to provide a ceramic oxide superconductor having improved mechanical strength, stability, higher Tc and larger critical current density.

Another object of the present invention is to provide a ceramic oxide superconductor which is thermally stable and hardly suffers from breakage of superconductive state even in the form of a wire.

Accordingly, the present invention provides a ceramic oxide superconductive composite material comprising a ceramic oxide superconductor and a non-superconductive material comprising at least one element, said non-superconductive material not reacting with any of the elements of the ceramic oxide superconductor and being filled in the pores of the superconductor, with the proviso that the non-superconductor material is not Ag.

### BRIEF DESCRIPTION OF DRAWINGS

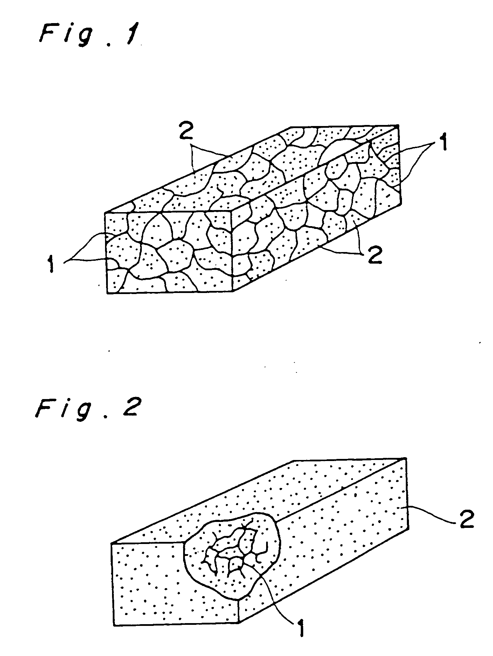

Fig. 1 is a perspective view of one embodiment of a ceramic oxide superconductive composite material according to the present invention, and Fig. 2 is a partly cut out perspective view of another embodiment of a ceramic oxide superconductive composite material according to the present invention.

### DETAILED DESCRIPTION OF THE INVENTION

The ceramic oxide superconductor comprises (1) at least one element selected from the elements of la, IIa and IIIa groups of the periodic table, (2) at least one element selected from the elements of Ib, IIb, IIIb, IVa and VIIIa groups of the periodic table, and (3) at least one element selected from the group consisting of oxygen, boron, carbon, nitrogen, fluorine and sulfur.

Examples of the la group elements are Li, Na, K, Rb, Cs and Fr, and examples of the Ib group elements are Cu, Ag and Au.

Examples of the IIa group elements are Be, Mg, Ca, Sr, Ba and Ra, and examples of the IIb group elements are Zn, Cd and the like.

Examples of the IIIa elements are Sc, Y and lanthanoids (e.g. La, Ce, Pr, Nd, Pm, Sm, Eu, Gd, Tb, Dy, Ho, Er, Tm, Yb and Lu) and actinoids (e.g. Ac), and examples of IIIb group elements are Al, Ga, In and Tl.

Among the above exemplified elements, those selected from the Ib group elements, the IIa group elements, the IIIa group elements, lanthanoids, oxygen, carbon and sulfur are preferred. Among the Ib group elements, Cu and Ag are more preferred, among the IIa group elements. Sr and Ba are more preferred and among the IIIa group elements, Sc and Y are more preferred.

Preferably, the ceramic oxide superconductor has a composition of the formula:

(M¹ ₁₋ₓM² ₓ)M³ _{y}M⁴ _{z} (I)

wherein M¹ is at least one element selected from the IIa group elements. M² is at least one element selected from the IIIa group elements, M³ is at least one element selected from Ib, IIb, IIIb, IVa and VIIIa group elements, M⁴ is at least one selected from the group consisting of oxygen, boron, carbon, nitrogen, fluorine and sulfur, x is an atomic ratio of M² to (M⁴ + M²) and not smaller than 0.1 and not larger than 0.9 (0.1≦x≦0.9), and y and z are atomic ratios of M³ and M⁴ to (M¹ + M²) and not smaller than 0.4 and not larger than 3.0, and not smaller than 1 and not larger than 5, respectively (0.4≦y≦3.0 and 1≦z≦5).

As the element M¹ of the formula (I), Ca, Sr, Ba and Ra, particularly Ba and Sr are preferred. As the element M², Sc, Y, lanthanoids and actinoids, particularly, Y, La, Ce, Nd and Yn are preferred. As the element M³, Cu, Ag, Zn, Cd, Ga, In, Fe, Co, Ni and Ti, particularly Cu, Fe, Co, Ni and Ti are preferred.

Examples of the superconductor having the above composition are Ba-Y-Cu-O, Ba-La-Cu-O, Sr-La-Cu-O type superconductors. The ratios of elements are arbitrarily selected in the ranges of the above definitions.

When a combination of Y-Ba, La-Ba or Sr-Ba is selected as a combination of M¹ and M², the atomic ratio of Y (Y + Ba) is preferably from 0.06 to 0.94, more preferably from 0.1 to 0.4, the atomic ratio of Ba (La + Ba) is preferably from 0.04 to 0.96, more preferably from 0.08 to 0.45, and the atomic ratio of Sr (La + Sr) is preferably from 0.03 to 0.95, more preferably from 0.05 to 0.1.

When any one of the atomic ratios is outside the above defined range, Tc of the produced superconductor decreases.

Preferably, the atomic ratios of the element M³ and oxygen to (M¹ + M²) are from 1:0.4 to 1:3.0 and from 1:1 to 1:5, respectively. At these atomic ratios, the superconductor may have a crystal structure of perovskite type, quasi-perovskite type such as oxygen-defect perovskite type which has an orthorohmbic structure.

The group of the non-superconductive material includes ferromagnetic materials and paramagnetic materials. The ferromagnetic materials are Gd, Tb, Dy, Ho, Er, Tm, Fe, Ni and Co. The paramagnetic materials are Au, Pt, and Pb.

The ferro- or para-magnetic material is incorporated in the pores of the superconductor by sintering the superconductor component materials and the ferro- or para-magnetic material at a temperature between a melting point of such materials and the sintering temperature. An elevated pressure in the sintering step is preferred to impregnate the materials.

The weight ratio of the ferro- or para-magnetic material to the superconductor is from 1:1 to 1:9, preferably from 1:2 to 1:7.

When the ferromagnetic material is incorporated in the pores of the superconductor, it acts as a pinning point so that the critical current density increases since the magnetic flux tends to be gathered by the ferromagnetic material. When the para-magnetic material is composited with the superconductor, an interface between the superconductor matrix and the paramagnetic material acts as a pinning point and also electromagnetically stabilizes the superconductor.

Another example of the non-superconductive material is a stabilizing material. The stabilizing material stabilizes the superconductive properties of the superconductor and is selected from copper, aluminum, copper which contains aluminum dispersed therein or a copper-nickel alloy. Among them, copper and aluminum, particularly aluminum having purity of 99.99 % or higher are preferred.

The stabilizing material is filled in the pores of the superconductor by immersing the sintered oxide superconductor in the molten stabilizing material such as aluminum. Another process for making the composite comprises filling a solder and the stabilizer in the pores.

The weight ratio of the stabilizing material to the superconductor is from 5:1 to 1:9, preferably from 1.2 to 1.7.

The stabilizing material is filled in pores of the ceramic oxide superconductor. Although the ceramic oxide superconductor which is produced by sintering is porous, it is possible to form a thin film of superconductor on cell walls and or outer surfaces of a resin foam so as to increase porosity of the superconductor. A typical method for producing such porous superconductor will be explained below.

In the cells and or on the outer surfaces of a foam of thermoplastic resin such as polyurethane, polyethylene, polypropylene and polystyrene, preferably a foam having open cells or a porously formed copper body, a solution of a superconductor forming raw material (preferably alcoholate) which has been prepared by a so-called so-gel method is applied, dried and sintered in the air. Then, the resin or copper is removed by melting or burning it. The remaining superconductor formed from the raw material present in the cells has relatively larger porosity and of desired shape.

Since the thus formed superconductor has a larger surface area and is supplied with a larger amount of oxygen during sintering, it has better superconductive properties such as higher Tc.

The stabilizing material in a melt state is then filled in the pores of the porous superconductor. The produced superconductor has a structure shown in Fig. 1 which comprises a porous superconductor 1 and a stabilizing material 2 filled in the pores.

Fig. 2 shows another embodiment of the stabilizing material filled superconductor. In this embodiment, the stabilizing material is not only filled in the pores but also coated on the outer surfaces of the superconductor 1. Accordingly, the superconductor is embedded in the stabilizing material so that protection and strength of the superconductor 1 are improved.

### PREFERRED EMBODIMENTS OF THE INVENTION

The present invention will be illustrated by the following Examples.

### Example 1

Y₂O₃ powder (3.78 g), BaCO₃ powder (13.22 g) and CuO powder (7.99 g) were sintered in the air at 940°C for 24 hours. The prepared superconductor material was immersed in melt lead kept at 400 °C to fill the pores of superconductor with lead to produce a non-porous superconductive composite material.

The non-porous superconductive composite material had a Tc of 90K, which is substantially the same as that of the superconductor which was not filled with lead. The critical current density of the non-porous superconductive composite material was 50 A/cm² while that of the superconductor which was not filled with lead was 10 A/cm². Further, the strength of non-porous superconductive composite material was improved and not broken during handling. The superconductive properties were not changed when contacted with moisture.

### Example 2

Y₂O₃ powder (3.78 g), BaCO₃ powder (13.22 g), CuO powder (7.99 g) and metal iron powder (4.50 g) were sintered in the air at 940°C for 24 hours.

The produced iron-filled superconductive composite material had less porosity and better strength than a superconductor containing no iron, and its critical current density was 100 A/cm².

### Example 3

Ethanol (200 ml) and octyl alcohol (50 ml) were added to 1 (one) mole of yttrium isopropoxide. To the mixture, ethanol (100 ml) containing 2 moles of barium ethoxide was added and mixed. To the resulting solution, water (2.7 mole) and a mixed solution of nitric acid and ethanol containing copper acethylacetonato (200 ml) were gradually added. Then, the mixture was heated and refluxed for 3 hours. The resulting sol solution was applied on surfaces of a porous body made of polyurethane foam and slowly dried. When it was dried in the air at room temperature for about 10 days and then at about 900°C for 10 hours, the polyurethane foam was completely burnt out to leave a porous oxide superconductor material which might comprise YBa₂Cu₃Oₓ. Its onset temperature was about 100K and it became completely superconductive at about 83K.

When the same mixture of raw materials was applied on a solid copper material and dried in the same manner as above, the produced superconductor became completely superconductive at about 60K.

From the above results, the superconductor produced by supplying enough oxygen had better superconductive properties.

As understood from the above description, since the pores of the superconductor of the present invention are filled with a certain material, it has sufficient compression strength, water resistance and higher critical temperature.

Since the porosity is decreased and in turn the density is increased, overall specific heat is increased and stable against thermal disturbance. Therefore, an element such as a superconductive magnet has improved reliance and is easily used.

Since it is difficult to adhere a solder or to adhere a piece of metal to the conventional superconductor itself, it is very hard to form a terminal, for achieving a high current density. For example, as a current lead or a voltage terminal, a silver past which is less reliable is conventionally used. However, according to the present invention, a piece of metal can be adhered to the ferromagnetic material, paramagnetic material and stabilizing material by, for example, soldering. Therefore, no heat is generated by the terminal and high current density can be achieved.

When the superconductor of the present invention is processed in the form of a wire, the filled stabilizing material acts as a by-pass for electric current, so that the thermal stability of the wire is improved.

## Claims

1. A ceramic oxide superconductive composite material comprising a ceramic oxide superconductor and a non-superconductive material comprising at least one element, said non-superconductive material not reacting with any of the elements of the ceramic oxide superconductor and being filled in the pores of the superconductor,
said non-superconductive material being selected from a ferromagretic material consisting of Gd, Tb, Dy, Ho, Er, Tm, Fe, Ni or Co; or from a paramagnetic material consisting of Au, Pt or Pb; or
from a stabilizing material consisting of Cu, Al, Cu which contains Al dispersed therein, or a Cu-Ni alloy;
the weight ratio of the ferro- or paramagnetic material to the superconductor being from 1:1 to 1:9; and
the weight ratio of the stabilizing material to the superconductor being from 5 : 1 to 1 : 9.

2. The ceramic oxide superconductive composite material according to claim 1, wherein the superconductor comprises (1) at least one element selected from the elements of Ia, IIa and IIIa groups of the periodic table. (2) at least one element selected from the elements of Ib IIb, IIIb, IVa and VIIIa groups of the periodic table, and (3) at least one element selected from the group consisting of oxygen, boron, carbon, nitrogen, fluorine and sulfur.

3. The ceramic oxide superconductive composite material according to claim 2, wherein the superconductor has a composition of the formula:
(M¹ ₁₋ₓM² ₓ)M³ _{y}M⁴ _{z} (I)
wherein M¹ is at least one element selected from the IIa group elements, M² is at least one element selected from the IIIa group elements. M³ is at least one element selected from Ib, IIb, IIIb, IVa and VIIIa group elements. M⁴ is at least one element selected from the group consisting of oxygen, boron, carbon, nitrogen, fluorine and sulfur, x is not smaller than 0.1 and not larger than 0.9, y is not smaller than 0.4 and not larger than 3.0, and z is not smaller than 1 and not larger than 5.

4. The ceramic oxide superconductive composite material according to claim 3, wherein M¹ is Ba, M² is an element selected from the group consisting of Sc, Y and La.

5. The ceramic oxide superconductive composite material according to claim 1, wherein the non-superconductive material is a ferromagnetic material.

6. The ceramic oxide superconductive composite material according to claim 1, wherein the non-superconductive material is a paramagnetic material.

7. The ceramic oxide superconductive composite material according to claim 1, wherein the non-superconductive material is a stabilizing material.

8. The ceramic oxide superconductive composite material according to claim 7, wherein the superconductor is further surrounded by the stabilizing material.

9. The ceramic oxide superconductive composite material according to claim 7, wherein the stabilizing material is copper or aluminum.

10. The ceramic oxide superconductive composite material according to claim 7, wherein the stabilizing material is aluminum having a purity of 99 99 % or higher.

## Patentansprüche

1. Supraleitendes Verbundmaterial aus Keramikoxid, umfassend einen Keramikoxid-Supraleiter und ein nicht-supraleitendes Material, umfassend zumindest ein Element, wobei das nicht-supraleitende Material nicht mit irgendeinem der Elemente des Keramikoxid-Supraleiters reagiert und in die Poren des Supraleiters gefüllt ist, wobei das nicht-supraleitende Material aus einem ferromagnetischen Material, bestehend aus Gd, Tb, Dy, Ho, Er, Tm, Fe, Ni oder Co; oder aus einem paramagnetischen Material, bestehend aus Au, Pt oder Pb; oder aus einem stabilisierenden Material bestehend aus Cu, Al, Cu, das darin dispergiertes Al enthält, oder einer Cu-Ni Legierung ausgewählt ist, wobei das Gewichtsverhältnis des ferro- oder paramagnetischen Materials zu dem Supraleiter von 1:1 bis 1:9 ist und das Gewichtsverhältnis des stabilisierenden Materials zu dem Supraleiter von 5:1 bis 1:9 ist.

2. Supraleitendes Verbundmaterial aus Keramikoxid nach Anspruch 1, **dadurch gekennzeichnet, dass** der Supraleiter (1) zumindest ein Element, ausgewählt aus den Elementen der Gruppen Ia, IIa und IIIa des Periodensystems, (2) zumindest ein Element, ausgewählt aus den Elementen der Gruppen Ib, IIb, IIIb, IVa und VIIIa des Periodensystems, und (3) zumindest ein Element, ausgewählt aus der Gruppe, bestehend aus Sauerstoff, Bor, Kohlenstoff, Stickstoff, Fluor und Schwefel, umfasst.

3. Supraleitendes Verbundmaterial aus Keramikoxid nach Anspruch 2, **dadurch gekennzeichnet, dass** der Supraleiter eine Zusammensetzung der Formel (I) aufweist
(M¹ ₁₋ₓM² ₓ)M³ _{y}M⁴ _{z} (I)
worin M¹ zumindest ein Element ist, ausgewählt aus den Elementen der Gruppe IIa, worin M² zumindest ein Element ist, ausgewählt aus den Elementen der Gruppe IIIa, worin M³ zumindest ein Element ist, ausgewählt aus den Elementen der Gruppe Ib, IIb, IIIb, IVa und VIIIa, worin M⁴ zumindest ein Element ist, ausgewählt aus der Gruppe, bestehend aus Sauerstoff, Bor, Kohlenstoff, Stickstoff, Fluor und Schwefel, worin x nicht kleiner ist als 0,1 und nicht grösser ist als 0,9, worin y nicht kleiner ist als 0,4 und nicht grösser ist als 3,0, und worin z nicht kleiner ist als 1 und nicht grösser ist als 5.

4. Supraleitendes Verbundmaterial aus Keramikoxid nach Anspruch 3, **dadurch gekennzeichnet, dass** M¹ Ba ist, dass M² ein Element ist, ausgewählt aus der Gruppe, die aus Sc, Y und La besteht.

5. Supraleitendes Verbundmaterial aus Keramikoxid nach Anspruch 1, **dadurch gekennzeichnet, dass** das nicht-supraleitende Material ein ferromagnetisches Material ist.

6. Supraleitendes Verbundmaterial aus Keramikoxid nach Anspruch 1, **dadurch gekennzeichnet, dass** das nicht-supraleitende Material ein paramagnetisches Material ist.

7. Supraleitendes Verbundmaterial aus Keramikoxid nach Anspruch 1, **dadurch gekennzeichnet, dass** das nicht-supraleitende Material ein stabilisierendes Material ist.

8. Supraleitendes Verbundmaterial aus Keramikoxid nach Anspruch 7, **dadurch gekennzeichnet**, das der Supraleiter weiterhin durch das stabilisierende Material umgeben ist.

9. Supraleitendes Verbundmaterial aus Keramikoxid nach Anspruch 7, **dadurch gekennzeichnet, dass** das stabilisierende Material Kupfer oder Aluminium ist.

10. Supraleitendes Verbundmaterial aus Keramikoxid nach Anspruch 7, **dadurch gekennzeichnet, dass** das stabilisierende Material Aluminium mit einer Reinheit von 99,99 % oder höher ist.

## Revendications

1. Matériau composite supraconducteur en céramique oxyde comprenant un supraconducteur en céramique oxyde et un matériau non supraconducteur comprenant au moins un élément, ledit matériau non supraconducteur ne réagissant pas avec l'un quelconque des éléments du supraconducteur en céramique oxyde et étant introduit dans les pores du supraconducteur, ledit matériau non supraconducteur étant choisi parmi un matériau ferromagnétique consistant en Gd, Tb, Dy, Ho, Er, Tm, Fe, Ni ou Co ; ou un matériau paramagnétique consistant en Au, Pt ou Pb ; ou un matériau stabilisant consistant en Cu, Al, Cu qui contient Al à l'état dispersé, ou un alliage Cu-Ni ;
le rapport massique du matériau ferro- ou paramagnétique au supraconducteur étant de 1:1 à 1:9 ; et le rapport massique du matériau stabilisant au supraconducteur étant de 5:1 à 1:9.

2. Matériau composite supraconducteur en céramique oxyde selon la revendication 1, où le supraconducteur comprend (1) au moins un élément choisi parmi les éléments des groupes Ia, IIa et IIIa du tableau périodique des éléments, (2) au moins un élément choisi parmi les éléments des groupes Ib, IIb, IIIb, IVa et VIIIa du tableau périodique des éléments, et (3) au moins un élément choisi dans le groupe comprenant l'oxygène, le bore, le carbone, l'azote, le fluor et le soufre.

3. Matériau composite supraconducteur en céramique oxyde selon la revendication 2, où le supraconducteur a une composition de formule :
(M¹ ₁₋ₓM² ₓ)M³ _{y}M⁴ _{z} (I)
dans laquelle M¹ est au moins un élément choisi parmi les éléments du groupe IIa, M² est au moins un élément choisi parmi les éléments du groupe IIIa, M³ est au moins un élément choisi parmi les éléments des groupes Ib, IIb, IIIb, IVa et VIIIa, M⁴ est au moins un élément choisi dans le groupe consistant en l'oxygène, le bore, le carbone, l'azote, le fluor et le soufre, x n'est pas inférieur à 0,1 et n'est pas supérieur à 0,9, y n'est pas inférieur à 0,4 et n'est pas supérieur à 3,0 et z n'est pas inférieur à 1 et n'est pas supérieur à 5.

4. Matériau composite supraconducteur en céramique oxyde selon la revendication 3, où M¹ est Ba, M² est un élément choisi dans le groupe consistant en Sc, Y et La.

5. Matériau composite supraconducteur en céramique oxyde selon la revendication 1, où le matériau non supraconducteur est un matériau ferromagnétique.

6. Matériau composite supraconducteur en céramique oxyde selon la revendication 1, où le matériau non supraconducteur est un matériau paramagnétique.

7. Matériau composite supraconducteur en céramique oxyde selon la revendication 1, où le matériau non supraconducteur est un matériau stabilisant.

8. Matériau composite supraconducteur en céramique oxyde selon la revendication 7, où le supraconducteur est entouré en outre par le matériau stabilisant.

9. Matériau composite supraconducteur en céramique oxyde selon la revendication 7, où le matériau stabilisant est du cuivre ou de l'aluminium.

10. Matériau composite supraconducteur en céramique oxyde selon la revendication 7, où le matériau stabilisant est de l'aluminium ayant une pureté de 99,99 % ou supérieure.
